# EUROPÄISCHE PATENTANMELDUNG

(11) **EP 0 945 903 A2**
(43) Veröffentlichungstag der Anmeldung: **29.09.1999**
(21) Anmeldenummer: 99103607.0
(22) Anmeldetag: 24.02.1999
(51) Int. Cl.: H01L 27/108

(54) **Halbleiterspeicher mit streifenförmiger Zellplatte**

(30) Priorität: 25.03.1998 DE 19813169
(71) Anmelder: SIEMENS AKTIENGESELLSCHAFT, 80333 München (DE)
(72) Erfinder: Owen, Richard, 93049 Regensburg (DE)

(57) **Zusammenfassung**

Bei einer Speicheranordnung mit Speicherzellen, bei der jede Speicherzelle einen Auswahltransistor und einen Grabenkondensator umfaßt, wobei die Speicherelektrode (12) von einem Substratbereich entlang der Grabenwand gebildet wird, und bei der die eine gemeinsame Gegenelektrode mehrerer Speicherzellen bildende Zellplatte (14) im Innern des Grabens gebildet ist, wird die Zellplatte an der Substratoberfläche in Form von Streifen strukturiert. Die Streifen können parallel zur Richtung von Zellreihen laufen oder mit dieser Richtung einen Winkel einschließen. Durch die streifenförmige Anordnung wird die minimale Strukturbreite im Bereich der Zellplatte verdoppelt.

## Beschreibung

Für Halbleiterspeicher mit dynamischem wahlfreien Zugang (DRAM-Speicher) gibt es eine Vielzahl von Speicherkonzepten. Generell sind es Ein-Transistor-Speicherzellen, die einen Speicherkondensator zur Speicherung einer logischen Größe und einen zugeordneten Auswahltransistor umfassen, wobei bei Ansteuerung des Auswahltransistors über eine Wortleitung die Information in den Speicherkondensator eingeschrieben bzw. ausgelesen werden kann. Aufgrund der ständig wachsenden Integrationsdichte muß der Platzbedarf der Ein-Transistor-Speicherzelle verringert werden.

Grundsätzlich lassen sich die Zellkonzepte folgendermaßen einteilen:
1. Planare Zellen, bei denen sowohl der Kondensator als auch der Transistor als planare Bauelemente realisiert werden,
2. stacked-capacitor-Zellen, bei denen der Speicherkondensator oberhalb des Transistors angeordnet ist, und
3. Grabenzellen, bei denen der Transistor an der Substratoberfläche und der Kondensator in einem im Substrat angeordneten Graben untergebracht ist und die Speicherelektrode entweder vom Substrat oder von einer isoliert im Graben angeordneten leitenden Schicht gebildet wird.

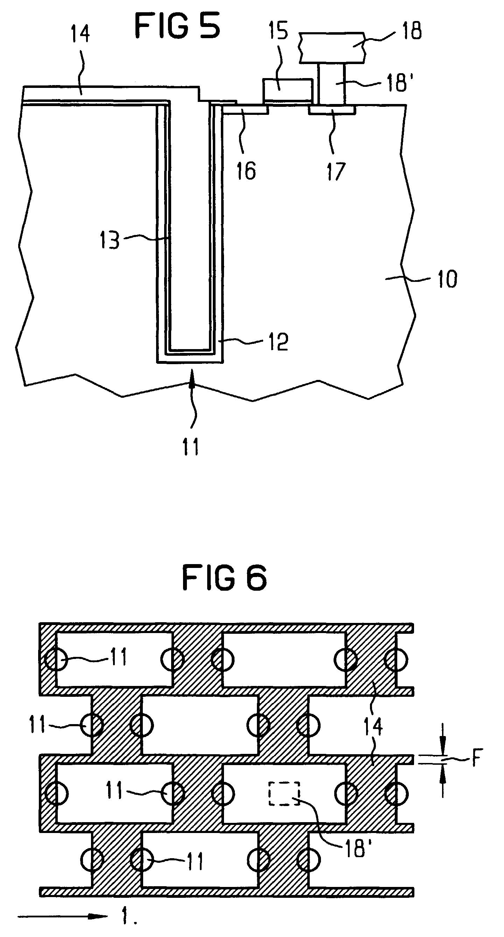

Eine Grabenzelle, bei der die Speicherelektrode vom Substrat bzw. einem Teil des Substrats gebildet wird, ist in Figur 5 im Querschnitt dargestellt. In ein Substrat 10 ist ein Graben 11 geätzt, wobei ein Teil des Substrats entlang der Grabeninnenwand durch geeignete Dotierung die Speicherelektrode 12 bildet. Die Grabeninnenwand ist mit einem Kondensatordielektrikum 13 versehen, und der Graben ist mit einer meist aus dotiertem Polysilizium bestehenden Schicht aufgefüllt, die die gemeinsame Gegenelektrode (Zellplatte) einer Vielzahl von Speicherzellen bildet. Der zugeordnete Auswahltransistor weist eine isoliert auf dem Substrat angeordnete Wortleitung 15 und zwei S/D-Gebiete 16, 17 auf, wobei eines (16) mit der Speicherelektrode 12 leitend verbunden ist, und das andere (17) später mit der Bitleitung 18 über einen Bitleitungskontakt 18' kontaktiert wird. Die Speicherzellen sind voneinander durch Isolationsgebiete (z.B. LOCOS oder shallow trench Isolation, nicht dargestellt) isoliert. Die Zellplatte 14 muß strukturiert werden, d.h. an den Stellen auf der Substratoberfläche entfernt werden, an denen der Auswahltransistor gebildet wird. Die dafür eingesetzte Ätzung kann isotrop oder anisotrop sein. In Figur 6 ist eine Aufsicht auf eine Speichermatrix (einen Ausschnitt aus einem Zellenfeld), d.h. eine Vielzahl von Speicherzellen, mit einer derartig strukturierten Zellplatte 14 (schraffiertes Gebiet) dargestellt.

In dem dargestellten Beispiel sind die Speicherzellen in einer ersten Richtung in einer Reihe angeordnet, benachbarte Reihen sind gegeneinander um eine Zellenlänge versetzt. Jeweils zwei in der ersten Richtung benachbarte Zellen sind spiegelsymetrisch angeordnet und besitzen einen gemeinsamen Bitleitungs-Kontakt 18', der in der Mitte der freigelegten Substratoberfläche angeordnet wird und der Übersichtlichkeit wegen nur bei einem Zellenpaar angedeutet ist. Grundsätzlich, d.h. auch bei anderen Layouts als dem gezeigten, wird die Zellplatte netzförmig strukturiert, wobei an den Stellen bis auf das Substrat reichende Öffnungen geätzt werden, an denen ein oder mehrere (hier zwei) Transistoren angeordnet werden sollen. Mit anderen Worten, die Löcher sind praktisch deckungsgleich mit dem aktiven Gebiet, und die verbleibende Zellplatte 14 überdeckt im wesentlichen das Isolationsgebiet zwischen den Speicherzellen. Dabei füllt die Zellplatte den Graben auf und überdeckt den Graben an der Substratoberfläche zumindest teilweise.

Eine derartige Anordnung läßt sich nicht beliebig verkleinern, da die Zellplatte fototechnisch strukturiert wird, die schmalsten Netzstege also mindestens die Breite F (fototechnisch erzeugbares Minimalmaß) haben müssen, bei einer isotropen Ätzung können sie noch schmaler hergestellt werden. Wenn die Netzstege sehr schmal sind, können sie aufbrechen oder reißen, so daß ein Ausfall der betroffenen Zellen die Folge ist.

Aufgabe der vorliegenden Erfindung ist es, eine Halbleiterspeicheranordnung anzugeben, bei der das erläuterte Problem vermieden wird. Diese Aufgabe wird durch eine Halbleiterspeicheranordnung mit den Merkmalen des Patentanspruchs 1 gelöst. Vorteilhafte Weiterbildungen sind in Unteransprüchen gekennzeichnet.

Bei der erfindungsgemäßen Speicheranordnung wird die Zellplatte nicht netzförmig, sondern in Streifen strukturiert. Die Zellplatte umfaßt also mehrere Zellplattenstreifen, die nebeneinander über das Zellenfeld verlaufen und lediglich ganz am Rand oder außerhalb des Zellenfeldes - also in einem Gebiet, in dem keine Speicherzellen liegen - miteinander verbunden sind. Zwischen den Streifen liegen die nicht von der Zellplatte überdeckten Gebiete ebenfalls streifenförmig vor. In den nicht überdeckten Gebieten werden die Transistoren gebildet. Auch Teile des Isolationsgebietes zwischen Speicherzellen (LOCOS- oder STI-Isolation) liegen in den freien Streifen.

Die bei der konventionellen Anordnung (Figur 6) auftretenden schmalen Stege fallen weg bzw. können doppelt so breit sein, die Anzahl dieser Stege wird halbiert. Die Zelle kann also weiter verkleinert werden, da die auftretende Minimalstruktur doppelt so breit ist wie bei der konventionellen Anordnung.

Die Richtung der Zellplattenstreifen kann mit einer ersten Richtung, in der Reihen von Speicherzellen angeordnet sind, zusammenfallen, also mit der Bitleitungsrichtung. Dann verbindet ein Plattenstreifen die Speicherzellen von zwei benachbarten Zellreihen, in dem er diese beiden Zellreihen doppelkammartig überdeckt. Dabei werden die Kondensatorgräben zumindest teilweise überdeckt, während die Transistorbereiche frei bleiben. Der benachbarte Zellplattenstreifen verbindet die Speicherkondensatoren einer dritten und vierten Zellreihe, zwischen den Zellplattenstreifen befindet sich ein durchgehender freier Streifen.

Wenn bei dieser Anordnung zwei Bruchstellen oder ähnliche Fehler in demselben Zellplattenstreifen auftreten, fallen die dazwischen liegenden Zellen aus. Ein derartiger Fehler kann aber leicht mit Hilfe von redundanten Zellen repariert werden, da lediglich die Zellen zweier Bitleitungen betroffen sind. Mit den redundanten Zellen müssen also quasi einfach zwei Bitleitungen ersetzt werden und nicht eine Vielzahl verschiedener Kombinationen von Bit- und Wortleitungen.

Die Richtung der Zellplattenstreifen kann auch mit der ersten Richtung der Zellreihen einen Winkel einschließen. Ein Zellplattenstreifen verbindet dann Speicherzellen von mehr als zwei Zellreihen, nämlich von allen Zellreihen, die er überkreuzt. In jeder überkreuzten Zellreihe kann er, je nach Layout der Speicherzellen, einen oder mehrere Kondensatoren anschließen. Vorteil dieses Konzepts ist eine ggf. größere Packungsdichte.

Die Erfindung ist grundsätzlich bei allen Layouts von DRAMs des genannten Zellkonzepts (Grabenzelle mit im Graben angeordneter Zellplatte) anwendbar, insbesondere bei einem anderen Versatz der Zellreihen gegeneinander oder bei nicht spiegelsymetrisch angeordneten Gräben bzw. Zellen.

Die Erfindung wird im folgenden anhand von Ausführungsbeispielen, die in den Zeichnungen dargestellt sind, näher erläutert. Es zeigen:
- FIG 1:: eine Aufsicht auf einen Ausschnitt eines Zellenfeldes mit einer Zellplatte gemäß eines ersten Ausführungsbeispiels,
- FIG 2 bis 4:: weitere Ausführungsbeispiele,
- FIG 5:: einen Querschnitt durch eine Speicherzelle mit einer im Graben angeordneten Zellplatte, und
- FIG 6:: eine Aufsicht auf einen Ausschnitt eines Zellenfeldes mit einer konventionellen Zellplatte.

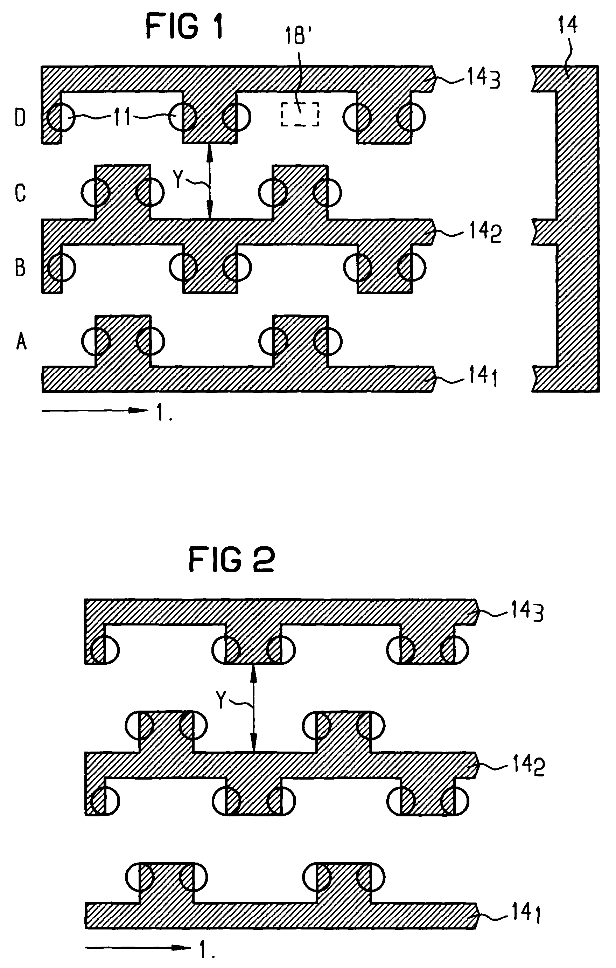

FIG 1: Obwohl allgemein anwendbar, wird die Erfindung an einem Zell-Layout mit in Reihen angeordneten Speicherzellen, wobei in einer Reihe jeweils zwei benachbarte Zellen spiegelsymetrisch angeordnet sind, und mit einem Versatz von einer Zellenlänge/Zellreihe beschrieben.

Der Zellenfeld-Ausschnitt zeigt in der ersten Richtung verlaufende Zellreihen, die mit A bis D bezeichnet sind. Jeweils zwei benachbarte Zellen in einer Reihe besitzen einen gemeinsamen Bitleitungskontakt 18', der der besseren Übersichtlichkeit wegen nur einmal in der Reihe D angedeutet ist. Entsprechend liegen auch jeweils zwei Gräben nebeneinander, die im Substrat in geeigneter Weise durch eine ausreichend hohe Dotierung gegeneinander dotiert sind. Benachbarte Zellreihen sind ebenfalls gegeneinander isoliert (beispielsweise durch eine Shallow-Trench-Isolation). Die Zellplatte ist in Form von Streifen strukturiert, die in der ersten Richtung verlaufen. Ein Zellplattenstreifen 14₂ verbindet die Kondensatorelektroden der Zellen in zwei benachbarten Reihen, hier der Reihen B und C, während ein daneben liegender Streifen 14₃ die Zellen der Reihe D (und einer weiteren Reihe außerhalb des dargestellten Ausschnitts) anschließt. Ein Zellplattenstreifen umfaßt eine Zentrallinie, die in der ersten Richtung zwischen den angeschlossenen Zellreihen verläuft, und weist Ausbuchtungen auf, die die angeschlossenen Kondensatorgräben zumindest teilweise überdeckt. Ein Zellplattenstreifen hat also eine doppelkammförmige Struktur. Die Zentrallinie kann doppelt so breit sein wie ein Steg bei der bekannten Anordnung, ohne daß der für die weitere Schaltung zur Verfügung stehende Raum - insbesondere die Breite Y des zellplattenfreien Raums - verringert wird. Benachbarte Zellplattenstreifen 14₂, 14₃ sind aufgrund der Doppelkammform durch einen freien Streifen voneinander getrennt.

In der rechten Bildhälfte ist ein Ausschnitt der Schaltung neben dem Zellenfeld dargestellt. Hier ist die Zellplatte durchgehend, so daß alle Plattenstreifen 14ᵢ leitend miteinander verbunden sind. Eine derartige Verbindung ist vorzugsweise auf beiden Seiten des Zellenfeldes vorgesehen. Je nach Anordnung der Speicherzellen am Rand des Zellenfeldes kann die Verbindung der Zellplattenstreifen auch im Randbereich des Zellenfeldes selbst erfolgen.

FIG 2 zeigt eine Variante des erläuterten Ausführungsbeispiels, bei der die Fläche der Zellplatte 14 bzw. der Zellplattenstreifen 14ᵢ reduziert wurde, indem auf elektrisch nicht wirksame Flächen verzichtet wurde. Die freien, von der Zellplatte 14 nicht bedeckten Gebiete werden dadurch vergrößert, insbesondere die Breite Y. Die vergrößerten freien Gebiete erhöhen den Spielraum bei der Anordnung der weiteren Speicherzellstrukturen in den höheren Ebenen, beispielsweise des Bitleitungskontaktes.

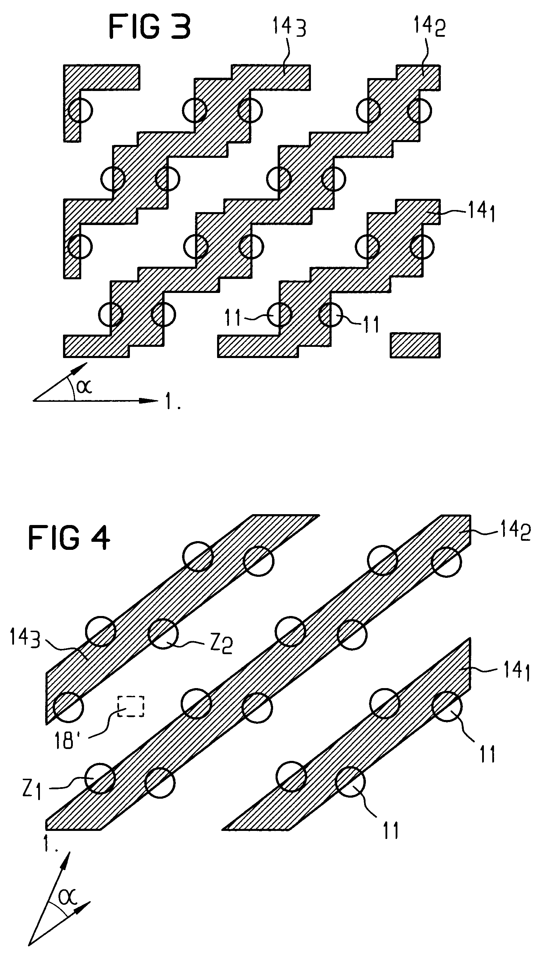

FIG 3: In dieser Ausführungsform verlaufen die Zellplattenstreifen 14ᵢ nicht in Richtung der Zellreihen, sondern schließen einen Winkel α mit dieser Richtung ein. Jeder Zellplattenstreifen verläuft also über eine Folge von Zellreihen und schließt in jeder Zellreihe mindestens einen - hier zwei - Kondensator an. In diesem Fall hat ein Zellplattenstreifen eine treppenartige Form, die insbesondere dadurch bedingt ist, daß das aktive Gebiet für die späteren Verfahrensschritte (Implantationen, Kontakte ...) freibleiben muß.

Die im wesentlichen parallel zueinander verlaufenden Zellplattenstreifen sind wiederum am Rand des Zellenfeldes miteinander verbunden. Auch in diesem Beispiel können die Zellplattenstreifen noch weiter minimiert werden durch Weglassen elektrisch nicht wirksamer Teile.

Fig. 4: zeigt eine abgewandelte Ausführungsform zu Fig.3, bei der ebenfalls die Zellplattenstreifen 14ᵢ nicht in Richtung der Zellreihen verlaufen, sondern einen Winkel α mit dieser Richtung einschließen. Dabei wurde die Fläche der Zellplattenstreifen 14ᵢ verringert, so daß die treppenförmige Anordnung in schräge Streifen übergeht. Die Richtung der Zellreihen kann entweder wie in den bisherigen Beispielen sein (also in der Zeichnung horizontal verlaufen). Andererseits kann die Zellreihenrichtung auch wie in der Figur dargestellt verlaufen (also in der Zeichnung schräg und annähernd vertikal); auch mit dieser ersten Richtung schließen die Zellplattenstreifen einen Winkel α ein. Der dargestellte Bitleitungskontakt 18' ist dann den mit Z1, Z2 gekennzeichneten Zellen bzw. Gräben zugeordnet, und das aktive Gebiet verläuft jeweils zwischen Graben und Bitleitungskontakt. Mit einer solchen Anordnung kann ggf. eine höhere Packungsdichte der Zellen erreicht werden : in der Figur ist erkennbar, daß die in der 1. Richtung benachbarten Gräben mit gemeinsamem Bitleitungskontakt einen größeren Abstand aufweisen als die in (im Sinne der Figur) horizontal benachbarten Gräben. In der ersten Richtung kann das Raster daher noch verkleinert werden. Die Wortleitungen, die bei dem gezeigten Layout vorzugsweise (im Sinne der Figur) horizontal verlaufen, können also mit noch geringerem Abstand verlegt werden. Inwieweit der Platzbedarf reduziert werden kann, hängt im Einzelfall vor allem davon ab, welche Maße - insbesondere die Abstände Bitleitungskontakt zu Graben und Gate zu Graben - am kritischsten sind.

Durch die Streifenstruktur der Zellplatte wird der Widerstand größer. Dies stellt jedoch im allgemeinen keine Beeinträchtigung der elektrischen Funktionen dar.

Für die Herstellung der Halbleiterspeicheranordnung können dem Fachmann geläufige Verfahren eingesetzt werden. Die Zellplatte wird vorzugsweise durch ganzflächige Abscheidung von dotiertem Polysilizium und isotrope oder anisotrope Ätzung unter Einsatz einer Fotomaske hergestellt, wobei erfindungsgemäß die Fotolackschicht streifenförmige Gebiete als spätere Zellplattenstreifen abdeckt.

## Patentansprüche

1. Halbleiterspeicheranordnung mit Speicherzellen in einem Substrat (10)
- bei der jede Speicherzelle einen Auswahltransistor (15, 16, 17) und einen Grabenkondensator (12, 13, 14) umfaßt, wobei die Speicherelektrode (12) von einem Substratbereich entlang der Grabenwand gebildet wird,
- bei der eine die gemeinsame Gegenelektrode mehrerer Speicherzellen bildende Zellplatte (14) aus einer leitenden Schicht im Innern des Grabens (11) gebildet ist,
**dadurch gekennzeichnet,** daß
die Zellplatte (14) an der Substratoberfläche eine streifenförmige Struktur (14ᵢ) aufweist.

2. Speicheranordnung nach Anspruch 1, bei der die Speicherzellen in Reihen (A, B, C, D) entlang einer ersten Richtung, die parallel zur Richtung einer Bitleitung (18) ist, angeordnet sind, bei der die Zellplattenstreifen (14ᵢ) in der ersten Richtung verlaufen und ein Zellplattenstreifen die Kondensatoren von zwei benachbarten Zellreihen anschließt.

3. Speicheranordnung nach Anspruch 1, bei der die Speicherzellen in Reihen (A, B, C, D) entlang einer ersten Richtung angeordnet sind und die Zellplattenstreifen (14ᵢ) mit der ersten Richtung einen Winkel (α) einschließen.

4. Speicheranordnung nach einem der Ansprüche 1 bis 3, bei der in jeder Zellreihe (A-D) jeweils zwei benachbarte Speicherzellen spiegelsymetrisch zueinander angeordnet sind und benachbarte Zellreihen um die Länge einer Speicherzelle gegeneinander versetzt sind.

5. Speicheranordnung nach einem der Ansprüche 1 bis 4, bei der die Zellplattenstreifen (14ᵢ) im Randbereich oder außerhalb des Zellenfeldes leitend miteinander verbunden sind.
